Europäisches Patentamt

European Patent Office

Office européen des brevets

(11) Veröffentlichungsnummer: **0 550 829 A1**

(12) **EUROPÄISCHE PATENTANMELDUNG**

(21) Anmeldenummer: **92120584.5**

(22) Anmeldetag: **02.12.92**

(51) Int. Cl.5: **H01L 41/08**, H01L 41/24

(30) Priorität: **05.12.91 DE 4140108**

(43) Veröffentlichungstag der Anmeldung:
**14.07.93 Patentblatt 93/28**

(84) Benannte Vertragsstaaten:
**DE GB NL**

(71) Anmelder: **Hoechst CeramTec
Aktiengesellschaft
Wilhelmstrasse 14
W-8672 Selb(DE)**

(72) Erfinder: **Helke, Günter, Dr.
Breite Strasse 29
W-8560 Lauf(DE)**
Erfinder: **Langer, Hans-Joachim
Holzstrasse 45
W-8560 Lauf(DE)**

(74) Vertreter: **Hoffmann, Peter, Dipl.-Chem. et al
Hoechst AG Zentrale Patentabteilung
Postfach 80 03 20
W-6230 Frankturt/Main 80 (DE)**

(54) **Verfahren zum Herstellen monolithischer Vielschichtverbunde für Aktuatoren aus ferroelektrischer Keramik.**

(57) Bei dem Verfahren zum Herstellen monolithischer Vielschichtverbunde für Aktuatoren aus ferroelektrischer Keramik, werden auf Folienkarten (1,1') aus grüner keramischer Masse elektrisch leitfähige Beläge (2) aufgebracht, die kreisförmig ausgebildet sind. Sie haben einen Radius $R_B$ und sind an ihren Rändern (4) mit je einer teilkreisförmigen Ausnehmung (3) mit Radius $R_A < R_B$ versehen. Die mit Belägen (2) versehenen Karten (1,1') werden so gestapelt, daß die Ausnehmungen (3) der Beläge (2) von Karte zu Karte versetzt zueinander angeordnet sind, wodurch sich im Stapel zwei Zonen bilden, die sich nicht überschneiden und in denen sich jeweils die Beläge (2) und Ausnehmungen (3) abwechseln. Der Kartenstapel wird laminiert. Nach dem Laminieren werden konzentrisch zu den Ausnehmungen (3) Rinnen (7) mit einem Radius $R_R < R_A$ gestanzt, danach die grünen Verbunde konzentrisch zu den Rändern (4) der Beläge (2) mit einem Raius $R_V$ aus dem Kartenstapel ausgestanzt und gebrannt, wobei $R_B > R_V \geq (R_B - R_R)$ sein soll.

Fig. 1

Rank Xerox (UK) Business Services
(3. 10/3.6/3.3. 1)

Die Erfindung betrifft ein Verfahren zum Herstellen monolithischer Vielschichtverbunde für piezoelektrische oder elektrostriktive Aktuatoren aus ferroelektrischer Keramik.

Piezoelektrische oder elektrostriktive Aktuatoren aus ferroelektrischer Keramik werden für Feinpositionierungen im Bereich bis 100 $\mu$m bei einem Auflösungsvermögen im Nanometer-Bereich verwendet, wie sie in der Präzisionsgerätetechnik, der Optik, der Lasertechnik etc. erforderlich sind.

Nach der EP-A-0 391 419 sind monolithische Vielschichtverbunde für Aktuatoren aus ferroelektrischer Keramik bekannt. Die Verbunde entstehen durch Stapeln von grünen Folien aus keramischem Material, die einseitig mit Elektroden versehen sind. Die Elektroden weisen eine Ausnehmung auf. Durch alternierendes Stapeln der Folien entstehen wechselseitig zwischen den Folien elektrodenfreie Zonen. Mit der Erfindung soll ein weiteres Herstellungsverfahren für Aktuatoren zur Verfügung gestellt werden.

Das erfindungsgemäße Verfahren ist dadurch gekennzeichnet, daß auf Folienkarten aus grüner keramischer Masse elektrisch leitfähige Beläge aufgebracht werden, die kreisförmig ausgebildet sind, einen Radius $R_B$ haben und an ihren Rändern mit je einer teilkreisförmigen Ausnehmung mit Radius $R_A < R_B$ versehen sind, die mit Belägen versehenen Karten so gestapelt werden, daß die Ausnehmungen der Beläge von Karte zu Karte versetzt zueinander angeordnet sind, wodurch sich im Stapel zwei Zonen bilden, die sich nicht überschneiden und in denen sich jeweils Beläge und Ausnehmungen abwechseln, der Kartenstapel laminiert wird, nach dem Laminieren konzentrisch zu den Ausnehmungen Rinnen mit einem Radius $R_R < R_A$ gestanzt werden, danach die grünen Verbunde konzentrisch zu den Rändern der Beläge mit einem Radius $R_V$ aus dem Kartenstapel ausgestanzt und gebrannt werden, wobei $R_B > R_V \geq (R_B - R_R)$ sein soll.

Die elektrisch leitfähigen Beläge können strukturiert z.B. durch Siebdrucken aufgebracht werden.

Im folgenden wird die Erfindung anhand von lediglich einen Ausführungsweg darstellenden Zeichnungen näher erläutert.

Es zeigt

Figur 1     eine Explosionszeichnung von zwei übereinanderliegenden Folienkarten;

Figur 2     die einzelnen Verfahrensschritte zum Herstellen des grünen Vielschichtverbundes aus einem Stapel aus Folienkarten und

Figur 3     den ausgestanzten Vielschichtverbund perspektivisch.

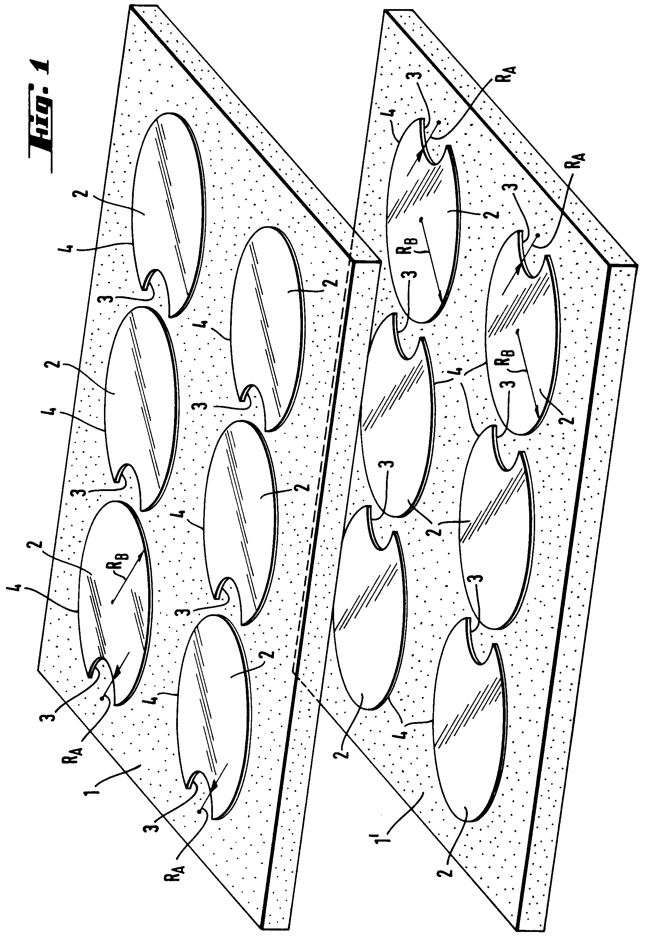

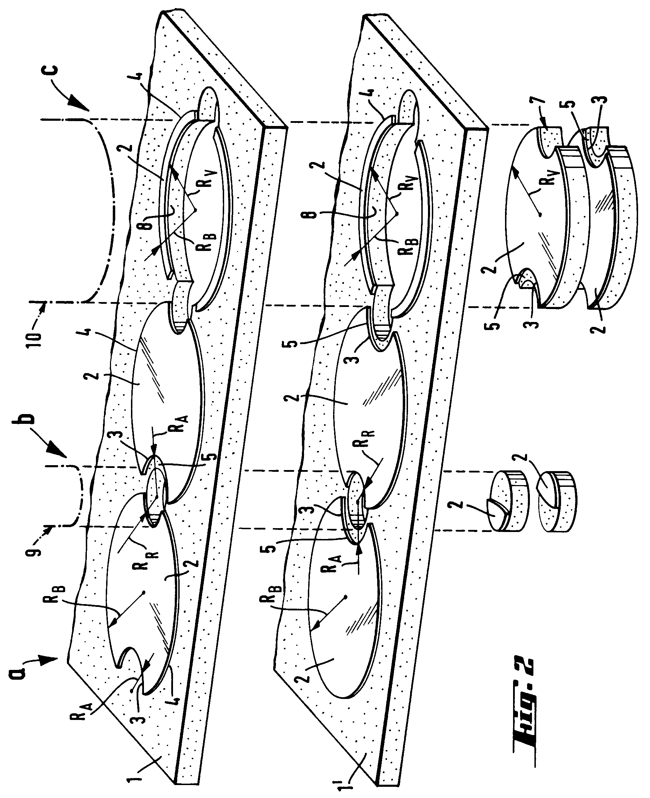

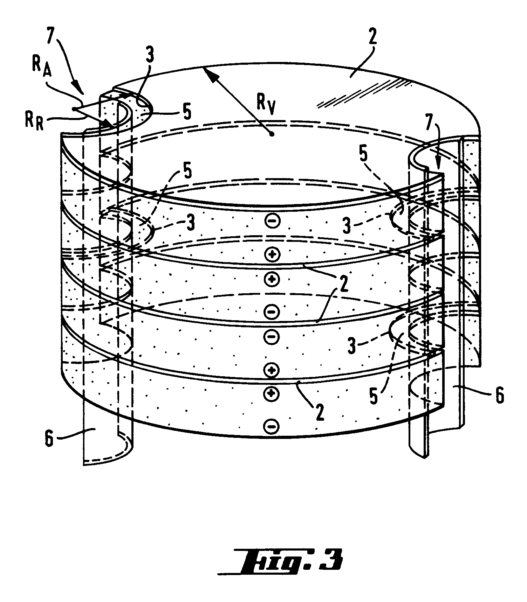

Auf die Folienkarte 1 aus ungebrannter keramischer Masse werden durch Siebdruck einseitig oder beidseitig elektrisch leitfähige Beläge 2 als kreisförmige Flächen mit einem Radius $R_B$ aufgebracht, die je an ihren Rändern 4 mit einer teilkreisförmigen Ausnehmung 3 versehen sind, die belagfrei ist. Für den Radius $R_A$ der Ausnehmungen 3 soll gelten $R_A < R_B$. Gemäß Figur 1 sind die Folienkarten 1,1' einseitig bedruckt. Die Beläge 2 mit Ausnehmungen 3 der Forlienkarte 1 sind gegenüber den Belägen 2 der Folienkarte 1' um einen Winkel von 180° verdreht angeordnet. Dadurch entstehen beim Stapeln der Folienkarten 1,1' Zonen, in denen sich von Karte zu Karte Beläge 2 und Ausnehmungen 3 abwechseln. Der Drehwinkel der Beläge 2 von Folienkarte 1 gegenüber den Belägen 2 von Folienkarte 1' muß nicht 180° sein, sondern kann beliebig gewählt werden, solange sich die beim Stapeln gebildeten Zonen nicht überschneiden. Die Ausführungsform gemäß den Figuren hat den Vorteil, daß der Aktuator aus Folienkarten mit einheitlichem Druckmuster aufgebaut werden kann. Die Ausnehmungen 3 bilden im Vielschichtverbund den Isolationsrand 5 für die Elektroden 6 (Figur 3). In Figur 2 sind die einzelnen Verfahrensschritte a, b, c zum Herstellen des grünen laminierten Vielschichtverbundes gemäß Figur 3 dargestellt. In Schritt a wird der kreisförmige elektrisch leitfähige Belag 2 mit Radius $R_B$ und die Ausnehmung 3 mit Radius $R_A$ auf die Folienkarte bzw. 1' aufgebracht. Schritt b zeigt das Ausstanzen der Rinnen 7 konzentrisch zu den Ausnehmungen 3 mit einem Radium $R_R < R_A$, wobei der Isolationsrand 5 gebildet wird. Schritt c zeigt das Ausstanzen des laminierten Vielschichtverbundes, wobei 8 das Stanzloch $R_V$ andeutet, das dem gebrannten Verbund gemäß Figur 3 entspricht. Mit (+) und (-) sind die Polaritäten der Elektroden 6 angedeutet und mit 9 und 10 das Stanzwerkzeug. In den Rinnen 7 kann jeweils die gemeinsame Kontaktierung (Stromzuführung) für die Elektroden gleicher Polarität untergebracht werden (nicht dargestellt). Die Elektroden 6 gleicher Polarität können z.B. durch Metallisieren der Rinnen 7 kontaktiert werden, was wegen des jeweiligen Isolationsrandes 5 problemlos ist (nicht dargestellt). Die Ausnehmungen 3 im Belag 2, sowie die Rinnen 7 können statt teilkreisförmige auch quadratische, rechteckige oder vieleckige Querschnitte aufweisen. Die einzelnen Folienkarten 1,1' können auch beidseitig mit elektrisch leitfähigen Belägen versehen werden, wobei darauf zu achten ist, daß die Ausnehmung 3 in den Belägen 2 von Vorder- und Rückseite der Folienkarte nicht übereinander zu liegen kommen.

**Patentansprüche**

1. Verfahren zum Herstellen monolithischer Vielschichtverbunde für Aktuatoren aus ferroelektrischer Keramik, dadurch gekennzeichnet, daß auf Folienkarten (1,1') aus grüner keramischer Masse elektrisch letfähige Beläge (2) aufgebracht werden, die kreisförmig ausgebildet sind, einen Radius $R_B$ haben und an ihren Rändern (4) mit je einer teilkreisförmigen Ausnehmung (3) mit Radius $R_A < R_B$ versehen sind, die mit Belägen (2) versehenen Karten (1,1') so gestapelt werden, daß die Ausnehmungen (3) der Beläge (2) von Karte zu Karte versetzt zueinander angeordnet sind, wodurch sich im Stapel zwei Zonen bilden, die sich nicht überschneiden und in denen sich jeweils die Beläge (2) und Ausnehmungen (3) abwechseln, der Kartenstapel laminiert wird, nach dem Laminieren konzentrisch zu den Ausnehmungen (3) Rinnen (7) mit einem Radius $R_R < R_A$ gestanzt werden, danach die grünen Verbunde konzentrisch zu den Rändern (4) der Beläge (2) mit einem Radius $R_V$ aus dem Kartenstapel ausgestanzt und gebrannt werden, wobei $R_B > R_V \geq (R_B - R_R)$ sein soll.

2. Verfahren nach Anspruch 1, dadurch gekennzeichnet, daß die elektrisch leitfähigen Beläge (2) strukturiert aufgebracht werden.

3. Verfahren nach Anspruch 1 oder 2, dadurch gekennzeichnet, daß die elektrisch leitfähigen Beläge (2) durch Siebdrucken auf die Folienkarten (1,1') aufgebracht werden.

**Fig. 1**

EP 0 550 829 A1

Fig. 2

*Fig. 3*

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| A | EP-A-0 337 373 (MATSUSHITA ELECTRIC IND CO LTD) <br> * Zusammenfassung; Abbildung 1 * <br> --- | 1-3 | H01L41/08 <br> H01L41/24 |
| A | DE-A-4 105 997 (HITACHI METALS LTD) <br> * Seite 4, Zeile 1-25; Abbildungen 1-5 * <br> --- | 1-3 | |
| A | EP-A-0 094 078 (NEC CORPORATION) <br> * Seite 10, Zeile 21 - Seite 11, Zeile 15; Abbildungen 1-23 * <br><br> ----- | 1-3 | |
| | | | **RECHERCHIERTE SACHGEBIETE (Int. Cl.5 )** |
| | | | H01L |

Der vorliegende Recherchenbericht wurde für alle Patentansprüche erstellt

| Recherchenort | Abschlußdatum der Recherche | Prüfer |
|---|---|---|
| DEN HAAG | 16 MAERZ 1993 | PELSERS L. |